# EUROPEAN PATENT APPLICATION

(11) **EP 4 203 009 A1**
(43) Date of publication of application: **28.06.2023**
(21) Application number: 22206289.5
(22) Date of filing: 09.11.2022
(51) Int. Cl.: H01L 23/15, H01L 23/498, H01L 21/48

(54) **LOW LOSS MICROSTRIP AND STRIPLINE ROUTING WITH BLIND TRENCH VIAS FOR HIGH SPEED SIGNALING ON A GLASS CORE**

(30) Priority: 21.12.2021 US 202117557948
(71) Applicant: INTEL Corporation, Santa Clara, CA 95054 (US)
(72) Inventor: ALEKSOV, Aleksandar, Chandler, 85286 (US); KAMGAING, Telesphor, Chandler, 85249 (US); DOGIAMIS, Georgios, Chandler, 85226 (US); PRABHU GAUNKAR, Neelam, Chandler, 85225 (US); STRONG, Veronica, Hillsboro, 97123 (US); RAWLINGS, Brandon, Chandler, 85248 (US); COLLINS, Andrew, Chandler, 85249 (US); SAIN, Arghya, Chandler, 85226 (US); PANDI, Sivaseetharaman, Chandler, 85225 (US)
(74) Representative: Goddar, Heinz J.

(57) **Abstract**

Embodiments disclosed herein include electronic packages. In an embodiment, the electronic package comprises a substrate with a first surface and a second surface opposite from the first surface, where the substrate comprises glass. In an embodiment, the electronic package further comprises a trace embedded in the substrate, where a width of the trace is less than a height of the trace. In an embodiment, the electronic package further comprises a first layer on the first surface of the substrate, where the first layer is a dielectric buildup film, and a second layer on the second surface of the substrate, where the second layer is the dielectric buildup film.

## Description

### TECHNICAL FIELD

Embodiments of the present disclosure relate to electronic packages, and more particularly to electronic packages with low loss microstrip and stripline routing with blind trench vias in a glass core.

### BACKGROUND

Providing high speed signaling is one of the critical components of every substrate package. These signal lines must fulfill two main criteria: 1) minimized insertion loss; and 2) excellent impedance match to the target given by the circuitry. Currently, high-speed signaling IO traces are configured either as single ended or differential pair traces in a layer of the substrate package. Generally, these high-speed traces are not structurally different from any other interconnect trace on the substrate package.

With respect to reducing insertion loss, attempts have been made to reduce the roughness of the trace. A smoother trace results in lower insertion losses. However, dielectric (buildup film) adhesion to the copper is negatively impacted when the copper is smoother. As such, new buildup film layers with improved adhesion properties are needed. The new materials may increase cost and may even increase losses if not with monolayer thickness.

Another way to minimize insertion loss, is to have traces that are wider than minimum allowed trace widths. However, the impedance decreases with increasing trace width. To keep the impedance at the target level, the separation to the ground features above and below the high-speed traces needs to be increased. This may lead to the use of architectures that are sometimes referred to as skip layers. Skip layer architectures may refer to instances where the buildup layer above and/or below the high-speed trace is left voided. Skip layers can increase the layer count. Additionally, the copper non-uniformity results in plating difficulties.

In current technologies, thick traces are only possible if the entire layer allows for high copper thicknesses. This will be limited to the impedance needs of all high-speed IO signals, as these do not always have identical impedance targets. In addition, plating height thickness in a package layer may be limited by mechanical package considerations, such as warpage. Additionally, this larger copper area and conductivity will require larger distances to the ground features surrounding the traces to adjust the impedance.

### BRIEF DESCRIPTION OF THE DRAWINGS

Figures 1A-1C are cross-sectional illustrations depicting a laser assisted etching process for forming vias through a core, in accordance with an embodiment.
Figures 2A-2C are cross-sectional illustrations depicting a laser assisted etching process for forming blind vias into a core, in accordance with an embodiment.
Figures 3A-3C are cross-sectional illustrations depicting a laser assisted etching process for forming a blind via into a core, in accordance with an embodiment.
Figure 4A is a plan view illustration of a core with signal and ground traces, in accordance with an embodiment.
Figure 4B is a cross-sectional illustration of Figure 4A at an end of the traces, in accordance with an embodiment.
Figure 4C is a cross-sectional illustration of Figure 4A at a point between the two ends of the traces, in accordance with an embodiment.
Figure 4D is a cross-sectional illustration of Figure 4A at a second end of the traces, in accordance with an embodiment.
Figure 5A-5D are a cross-sectional illustrations depicting a process for forming embedded traces in a glass core, in accordance with an embodiment.
Figures 6A-6E are cross-sectional illustrations depicting a process for forming embedded traces with a U-shaped cross-section, in accordance with an embodiment.
Figure 7A is a cross-sectional illustration of a core with traces that are embedded in the core and extend over a top surface of the core, in accordance with an embodiment.
Figure 7B is a cross-sectional illustration of a core with traces that are embedded into a top and bottom surface of the core, in accordance with an embodiment.
Figure 8A is a perspective view illustration of a core with a staggered, dual-sided, single-ended interconnect architecture, in accordance with an embodiment.
Figure 8B is a perspective view illustration of a core with a single-sided, single-ended interconnect architecture, in accordance with an embodiment.
Figure 8C is a perspective view illustration of a core with a single-sided differential signaling architecture, in accordance with an embodiment.
Figure 8D is a perspective view illustration of a dual-sided differential signaling pair with blind trench via grounds, in accordance with an embodiment.
Figure 8E is a perspective view illustration of a dual sided differential signaling pair with through trench via grounds, in accordance with an embodiment.
Figure 9 is a cross-sectional illustration of an electronic system with a package substrate that includes embedded traces for high-speed signaling in the core, in accordance with an embodiment.
Figure 10 is a schematic of a computing device built in accordance with an embodiment.

### EMBODIMENTS OF THE PRESENT DISCLOSURE

Described herein are electronic packages with low loss microstrip and stripline routing with blind trench vias in a glass core, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, high speed signaling requires minimized insertion loss, and excellent impedance matching to the target given by the circuitry. In order to meet these parameters, embodiments disclosed herein utilize traces that are embedded within the core of a package substrate. Particularly, the core may be a glass core in some embodiments. The traces may be formed in blind trenches into the core. As used herein, a blind trench refers to a trench that goes into, but not through, a thickness of the core. The ground traces may also be formed in blind trenches. The blind trenches may be formed with a laser assisted etching process that will be described in greater detail below.

Embodiments disclosed herein include benefits such as, low loss tangents. For example, certain glass types suitable for laser assisted etching may have loss tangents that are lower than those of any buildup film. Additionally, positioning the highest speed HSIO traces into the glass core may alleviate the need to rout such traces on a package buildup layer. As such, the need for skip layer plating and additional layers is avoided. Furthermore, it is to be appreciated that the trace width is the depth of the trace into the glass, which can be tens to hundreds of micrometers, further minimizing losses. With such an orientation, the spacing to the ground planes is now lateral and offers another degree of freedom to adjust the impedance.

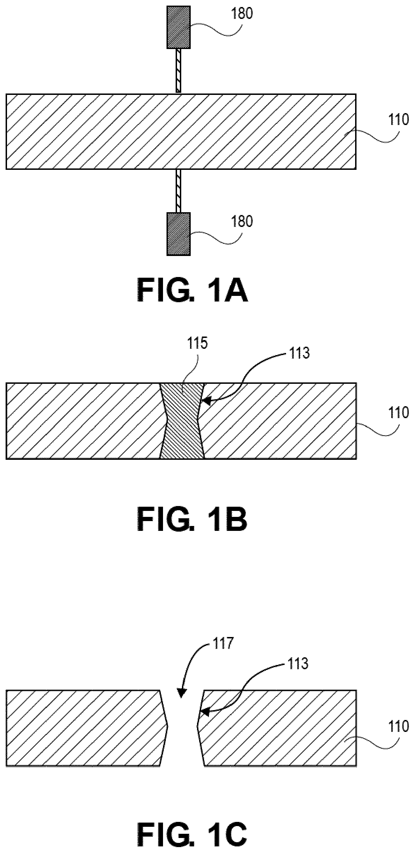

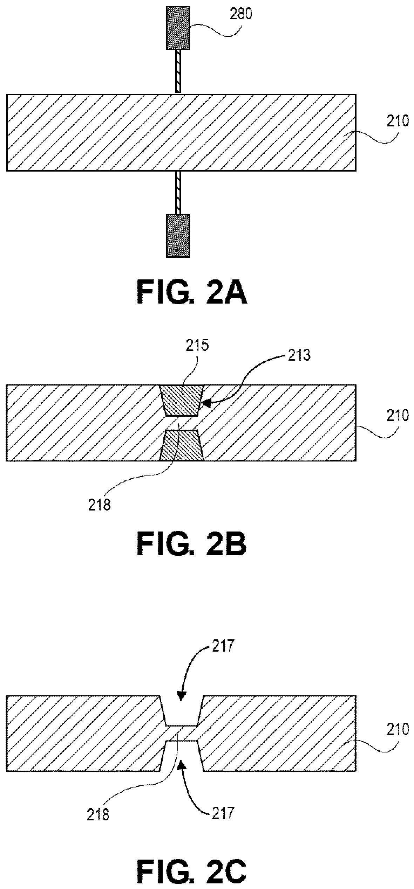

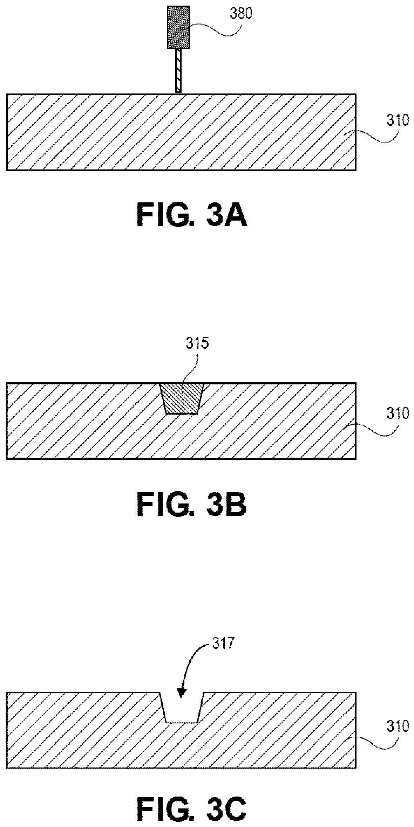

Referring now to Figures 1A-3C, three series of cross-sectional illustrations that depict processes for forming features in glass cores with laser assisted etching processes are shown, in accordance with an embodiment. In Figures 1A-1C, a through core via opening is formed. In Figures 2A-2C a pair of blind via openings on opposite surfaces of the core are formed. In Figures 3A-3C a blind via opening into the top surface of the core is formed. The openings formed in Figures 1A-3C can then be filled with materials (e.g., conductive materials) using various plating or other deposition processes in order to manufacture HSIO traces and ground traces/planes within a glass core.

Referring now to Figures 1A-1C, a series of cross-sectional illustrations depicting a process for fabricating openings in a glass core 110 is shown, in accordance with an embodiment.

Referring now to Figure 1A, a cross-sectional illustration of a glass core 110 is shown, in accordance with an embodiment. In an embodiment, the glass core 110 may have a thickness that is between approximately 50µm and approximately 1,000µm. As used herein, approximately may refer to a value that is within 10% of the stated value. For example, approximately 50µm may refer to a value between 45µm and 55µm. Though, it is to be appreciated that other thicknesses (larger or smaller) may also be used for the glass core 110. In an embodiment, a laser 180 is used to expose a region of the glass core 110. As shown in Figure 1A, the exposure may be made on both sides (i.e., the top surface of the glass core 110 and the bottom surface of the glass core 110). A single laser 180 may be used, or multiple lasers may be used. In an embodiment, the laser 180 is exposed over the glass core 110 at locations where via openings are desired.

Referring now to Figure 1B, a cross-sectional illustration of the glass core 110 after the laser 180 exposure is completed is shown, in accordance with an embodiment. As shown, the laser 180 exposure may result in the formation of exposed regions 115. The power of the laser results in a morphological change that alters the microstructure of the glass core 110. For example, the morphological change may include the transformation to a crystalline structure from an amorphous structure. Accordingly, the exposed region 115 is shown with a different shading than the glass core 110.

In an embodiment, the laser 180 exposure may result in an exposed region 115 that has a tapered sidewall 113. In the instance where both sides of the glass core 110 are exposed (as is the case shown in Figure 1A), the exposed region 115 may have a double tapered profile. That is, widths of the exposed region 115 at a top surface of the glass core 110 and at a bottom surface of the glass core 110 may be wider than a width at a middle of the glass core 110. In some instances, such a sidewall 113 profile may be referred to as an hourglass shaped profile.

Referring now to Figure 1C, a cross-sectional illustration of the glass core 110 after the exposed region 115 is removed is shown, in accordance with an embodiment. In an embodiment, removal of the exposed region 115 may result in the formation of a via opening 117. The via opening 117 may pass entirely through a thickness of the glass core 110. In an embodiment, the via opening 117 may be a high aspect ratio via opening 117. As used herein a "high aspect ratio" may refer to an aspect ratio (width: depth) that is approximately 5:1 or greater, with the width being measured at a narrowest point through a thickness of the via opening 117. In other embodiments, the aspect ratio of the via opening 117 may be approximately 10:1 or greater, approximately 20:1 or greater, or approximately 50:1 or greater.

Referring now to Figures 2A-2C, a series of cross-sectional illustrations depicting a process for forming blind structures into a glass core 210 is shown, in accordance with an embodiment. Instead of forming an opening entirely through the glass core 210, structures that extend partially through a thickness of the core 210 are provided.

Referring now to Figure 2A, a cross-sectional illustration of a glass core 210 is shown, in accordance with an embodiment. In an embodiment, the glass core 210 may be substantially similar to the glass core 110 described in greater detail above. For example, the glass core 210 may have a thickness between approximately 50µm and approximately 1,000µm. In an embodiment, lasers 280 may expose portions of the glass core 210. In an embodiment, the laser 280 exposure in Figure 2A may be different than the laser 180 exposure in Figure 1A. For example, an intensity or duration of the laser 280 exposure may be less than the intensity or duration of the laser 180 exposure in Figure 1A.

Referring now to Figure 2B, a cross-sectional illustration of the glass core 210 after exposed regions 215 are formed is shown, in accordance with an embodiment. In an embodiment, the exposed regions 215 do not extend entirely through a thickness of the glass core 210. For example, a region 218 may be provided between the top exposed region 215 and the bottom exposed region 215. In some instances, the exposed regions 215 still include tapered sidewalls 213. Since the exposed regions 215 are formed from only a single side, the sidewalls 213 may only have a single taper. That is, the exposed regions 215 may not be hourglass shaped.

Referring now to Figure 2C, a cross-sectional illustration of the glass core 210 after the exposed regions 215 are removed to form openings 217 is shown, in accordance with an embodiment. In an embodiment, the exposed regions 215 may be removed with an etching process that is selective to the exposed regions 215 over the rest of the glass core 210. As shown, the openings 217 do not extend entirely through the glass core 210. In such embodiments, the openings 217 may be referred to as blind openings since they do not pass through the glass core 210.

Referring now to Figures 3A-3C, a series of cross-sectional illustrations depicting a process for forming a blind opening 317 is shown, in accordance with an embodiment.

Referring now to Figure 3A, a cross-sectional illustration of a glass core 310 is shown, in accordance with an embodiment. In an embodiment, the glass core 310 may be substantially similar to the glass cores 110 and 210 described in greater detail above. For example, the glass core 310 may have a thickness between approximately 50µm and approximately 1,000µm. In an embodiment, a laser 380 may be used to expose a surface of the glass core 310. In contrast to embodiments described in greater detail above, the laser 380 exposure may only be provided on a single surface of the glass core 310.

Referring now to Figure 3B, a cross-sectional illustration of the glass core 310 after the laser exposure to form an exposed region 315 is shown, in accordance with an embodiment. In an embodiment, the exposed region 315 may be a region that has a morphology change compared to the rest of the glass core 310. For example, the morphology change may be the transition from an amorphous structure to a crystalline structure. In an embodiment, the exposed region 315 may not extend entirely through a thickness of the glass core 310. That is, the exposed region 315 may be suitable for forming blind structures.

However, it is to be appreciated that in some embodiments, a laser 380 exposure on a single surface of the glass core 310 can be used to form an exposed region 315 that extends through an entire thickness of the glass core 310. That is, it is not necessary to use an exposure on both sides of the glass core 310 in order to form through core structures. In such an embodiment, the sidewall profile of the exposed region 315 may have a single taper, instead of the hour-glass shaped taper shown in Figure 1B.

Referring now to Figure 3C, a cross-sectional illustration of the glass core 310 after the exposed region 315 is removed is shown, in accordance with an embodiment. In an embodiment, the removal of the exposed region 315 may result in an opening 317 being formed into the surface of the glass core 310. In an embodiment, the opening 317 may be a blind opening. In other embodiments, the opening 317 may pass entirely through a thickness of the glass core 310.

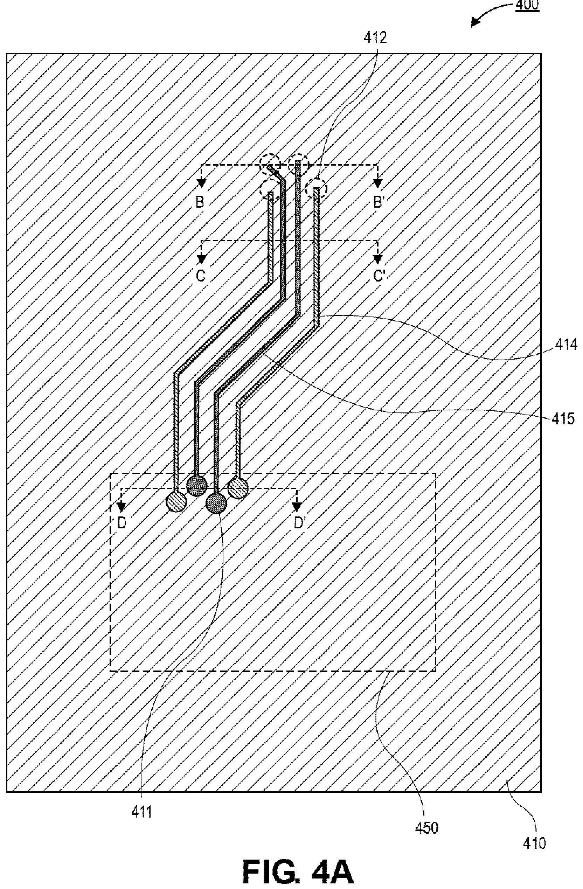

Referring now to Figure 4A, a plan view illustration of a portion of an electronic package 400 is shown, in accordance with an embodiment. In an embodiment, the electronic package 400 comprises a core 410. The core 410 may be a glass core made from a material that is compatible with laser assisted etching process, such as those described in greater detail above. In the illustrated embodiment, buildup layers above and below the core 410 are omitted for clarity.

In an embodiment, a plurality of traces 414 and 415 are provided on the core 410. The traces 414 may be ground traces, and the traces 415 may be signaling traces. Though, it is to be appreciated that the traces 414 and 415 may be substantially similar to each other in material composition and/or structure. In the plan view of Figure 4A, the traces 414 and 415 appear to be on a top surface of the core 410. However, it is to be appreciated that at least a portion of the traces 414 and 415 are embedded into the core, as will be described in greater detail below.

In an embodiment, first ends of the traces 414 and 415 may be located under a die shadow 450. The die shadow 450 is the location below a die that is coupled to the electronic package 400. In an embodiment, pads 411 may be provided on the first end of the traces 414 and 415. Second ends of the traces 414 and 415 may be provided outside of the die shadow 450. The second ends may terminate above pads 412. As indicated by the dashed lines, the pads 412 may be provided on a backside (or bottom side) surface of the core 410. At the second ends, the traces 414 and 415 may have a thickness that extends entirely through a thickness of the core 410 in order to contact the pads 412. In some instances, the second ends of the traces 414 and 415 may be referred to as vias.

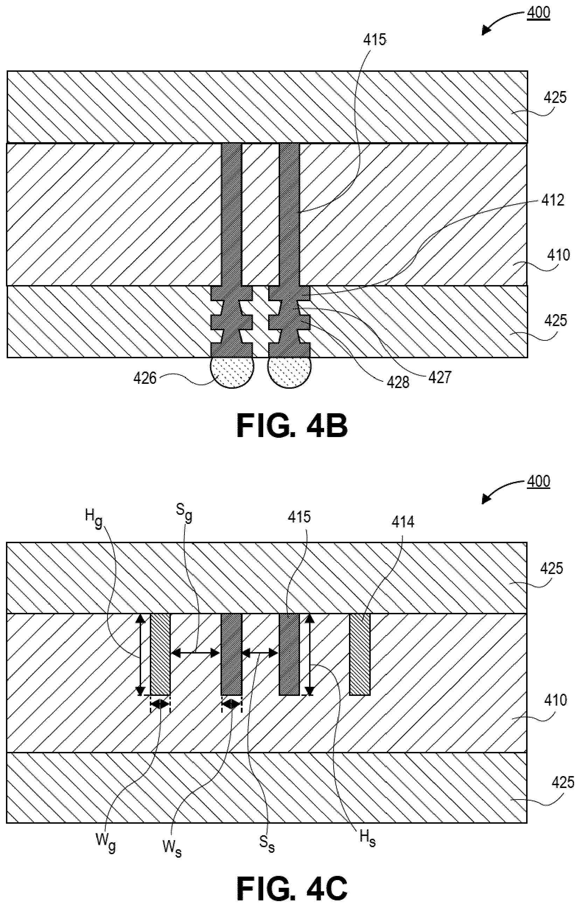

Referring now to Figure 4B, a cross-sectional illustration of the electronic package 400 in Figure 4A along line B-B' is shown, in accordance with an embodiment. As shown, the traces 415 extend through an entire thickness of the core 410. The traces 415 may have pads 412 on a bottom surface of the core 410. Vias 427 and pads 428 in the buildup layers 425 may couple the pads 412 to second level interconnects (SLIs) 426. While shown as BGA balls, it is to be appreciated that any SLI architecture may be used for the SLIs 426. For example, the SLIs 426 may include LGA interconnects or the like.

Referring now to Figure 4C, a cross-sectional illustration of the electronic package 400 in Figure 4A along line C-C' is shown, in accordance with an embodiment. As shown, the traces 415 and 414 are embedded in the core 410. However, the traces 415 may not extend entirely through a thickness of the core. In an embodiment, top surfaces of the traces 415 and 414 are substantially coplanar with a top surface of the core 410. As used herein, substantially coplanar may refer to two surfaces that are within approximately 2µm of being perfectly coplanar. In an embodiment, the traces 415 and 414 may have widths W_{g} and Wₛ that are smaller than the heights H_{g} and Hₛ. In the illustrated embodiment, the width W_{g} of the ground trace 414 is substantially similar to the width Wₛ of the signal trace 415, but it is to be appreciated that the two widths may be different. Similarly, the height H_{g} of the ground trace 414 is substantially similar to the height Hₛ of the signal trace 415, but it is to be appreciated that the two heights may be different. In the illustrated embodiment, the signal traces 415 may be spaced apart from each other by a spacing Sₛ, and the ground trace 414 may be spaced apart from the signal trace 415 by a spacing S_{g}. In an embodiment, the spacing Sₛ may be different than the spacing S_{g}. In other embodiments, the spacing Sₛ may be substantially similar to the spacing S_{g}.

The wide variety of variables (e.g., W_{g}, Wₛ, H_{g}, Hₛ, S_{g}, and Sₛ) allows for many degrees of freedom in order to provide signaling architectures with a desired electrical performance. Additionally, changes to the different variables do not require increasing the number of layers in the electronic package since the traces 414 and 415 remain in the core 410. That is, skip layer architectures are not needed since the ground planes 414 are laterally spaced away from the signaling traces 415. In an embodiment, the heights H_{g} and Hₛ may be between approximately 20µm and approximately 500µm. In a particular embodiment, the heights H_{g} and Hₛ may be between approximately 100µm and approximately 200µm. In an embodiment, the widths W_{g} and Wₛ may be between approximately 10µm and approximately 100µm. In an embodiment, the spacings S_{g} and Sₛ may be between approximately 20µm and approximately 500µm.

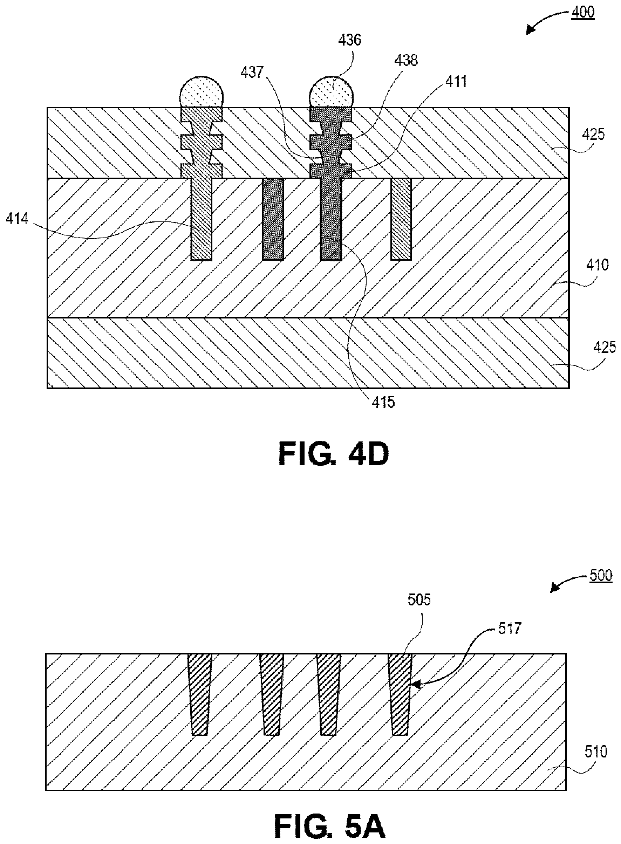

Referring now to Figure 4D, a cross-sectional illustration of the electronic package in Figure 4A along line D-D' is shown, in accordance with an embodiment. As shown, the end of the traces 414 and 415 may have pads 411. The pads 411 may be coupled to first level interconnects (FLIs) 436 by vias 437 and pads 438 that pass through the top buildup layers 425. The FLIs 436 may be any type of FLI architecture. For example, the FLIs 436 may be solder balls, or the like. As shown in Figure 4B and 4D, the connections to the SLIs 426 and the FLIs 436 may be made with vertical connections through the buildup layers 425. As such, all lateral routing of the traces 414 and 415 may be implemented in the glass core 410. Though, in some embodiments, there may be some lateral routing in the buildup layers 425.

Referring now to Figures 5A-5D, a series of cross-sectional illustrations depicting a process for forming traces similar to the traces 414 and 415 in Figure 4D is shown, in accordance with an embodiment. In an embodiment, the traces may be formed with a laser assisted etching process.

Referring now to Figure 5A, a cross-sectional illustration of an electronic package 500 with a core 510 is shown, in accordance with an embodiment. In an embodiment, the core 510 may have a thickness that is between approximately 50µm and approximately 1,000µm. In an embodiment, the core 510 may comprise glass that is compatible with laser assisted etching processes. For example, a laser exposure may be used to form exposed regions 505. The exposed regions 505 may have undergone a morphological change in order to be etch selective to the remainder of the core 510. For example, the exposed regions 505 may be crystalline, and the unexposed regions may be amorphous. As shown, the laser exposure process may result in exposed regions 505 that have tapered sidewalls 517.

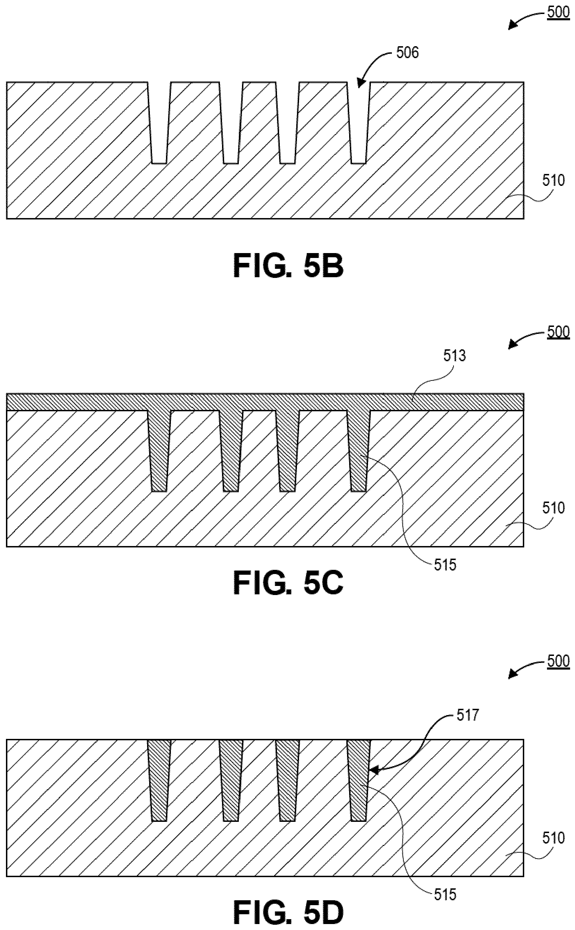

Referring now to Figure 5B, a cross-sectional illustration of the core 510 after an etching process is shown, in accordance with an embodiment. As shown, the etching process removes the exposed regions 505 to form blind openings 506. That is, the openings 506 pass into the core 510, but do not pass through an entire thickness of the core 510.

Referring now to Figure 5C, a cross-sectional illustration of the core 510 after a material deposition process is shown, in accordance with an embodiment. In an embodiment, a copper material or other conductive material may be disposed into the openings 506 in order to form blind vias 515. The deposition process may be any suitable plating process, such as an electroplating process. In some instances, an overburden layer 513 may be provided over a top surface of the core 510.

Referring now to Figure 5D, a cross-sectional illustration of the core 510 after the overburden 513 is removed is shown, in accordance with an embodiment. In an embodiment, the overburden 513 may be removed with a polishing process, such as a chemical mechanical polishing (CMP) process. The resulting electronic package 500 includes blind vias 515. The blind vias 515 may have tapered sidewalls 517 in some embodiments.

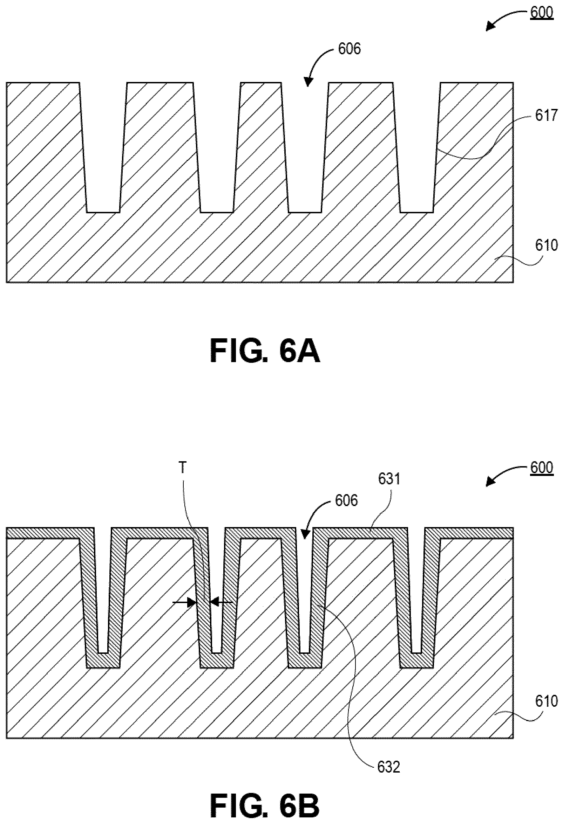

Referring now to Figures 6A-6E, a series of cross-sectional illustrations depicting a process for forming traces embedded in a core 610 of an electronic package 600 is shown, in accordance with an embodiment. In an embodiment, the traces are formed into blind openings, but do not entirely fill the blind opening. The remainder of the opening may be filled with an organic material. The partial filling of the blind openings may result in traces with a U-shaped cross-section. Such architectures have a decreased DC resistance as compared to a fully filled trench, but at the same time can have a significantly decreased AC resistance (if designed properly). This is because, at very high frequencies, the currents are crowded at the surface of the conductor. In such embodiments, the thickness of the copper may be approximately four times the skin depth at the operating frequency of the HSIO connection. For example, at 10GHz the skin depth in copper is approximately 650nm. So the copper thickness would ideally be at least approximately 2.6µm. At 30GHz the skin depth is about 380nm, and the copper thickness should be larger than approximately 1.5 µm.

Referring now to Figure 6A, a cross-sectional illustration of a core 610 of an electronic package 600 is shown, in accordance with an embodiment. As shown, an etching process is used to remove laser exposed regions to form blind openings 606. That is, the openings 606 pass into the core 610, but do not pass through an entire thickness of the core 610. In an embodiment, the sidewalls 617 of the blind openings 606 may be tapered.

Referring now to Figure 6B, a cross-sectional illustration of the core 610 after a material deposition process is shown, in accordance with an embodiment. In an embodiment, the material may be a conductive trace 632. Conductive material 631 may also be disposed over the top surface of the core 610. In an embodiment, the conductive trace 632 is substantially conformal to the shape of the blind openings 606. Additionally, the conductive traces 632 do not completely fill the blind openings 606. In an embodiment, the cross-sectional shape of the conductive traces 632 may sometimes be referred to as having a U-shaped cross-section. That is, a pair of vertical arms are coupled together proximate to bottom surfaces of the vertical arms. In an embodiment, a thickness T of the traces 632 may be between approximately 1 µm and approximately 51µm. Particularly, the thickness T of the traces 632 may be approximately four times the skin depth of a signal for a given frequency.

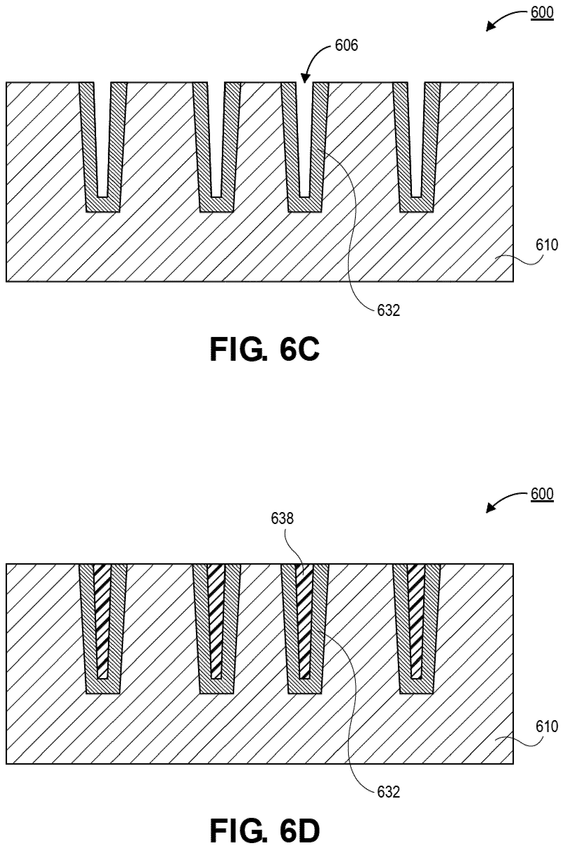

Referring now to Figure 6C, a cross-sectional illustration of the core 610 after the conductive material 631 from Figure 6B is removed is shown, in accordance with an embodiment. In an embodiment, the conductive material 631 over the top of the core 610 may be removed with a polishing process, such as a CMP process.

Referring now to Figure 6D, a cross-sectional illustration of the core 610 after a plug 638 is disposed into the blind openings 606 is shown, in accordance with an embodiment. In an embodiment, the organic material may be a material with good flow abilities capable of plugging the openings 606. For example, the plug 638 may be an organic polymer, a silica filled polymer, or the like. In other embodiments, the plug 638 may be part of a laminated buildup layer disposed over the core 610.

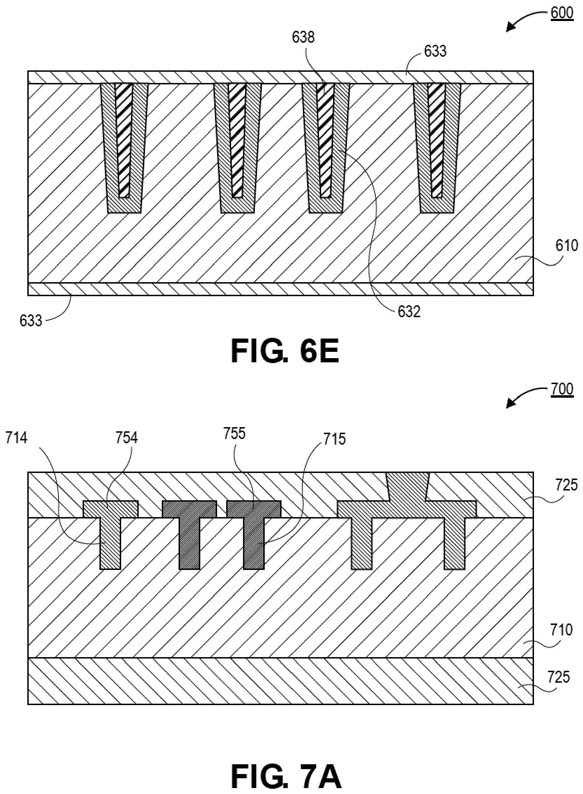

Referring now to Figure 6E, a cross-sectional illustration of the core 610 after a dielectric layers 633 are disposed over and under the core 610 is shown, in accordance with an embodiment. In an embodiment, the dielectric layer 633 may be the same material as the plugs 638. In other embodiments, the dielectric layer 633 may be buildup layers suitable for providing additional routing (not shown) above and below the core 610.

Referring now to Figure 7A, a cross-sectional illustration of an electronic package 700 is shown, in accordance with an additional embodiment. In an embodiment, the electronic package 700 comprises a core 710. Buildup layers 725 may be provided above and below the core 710. In an embodiment, embedded traces 714 and 715 may be provided in the core 710. The embedded traces 714 and 715 may be substantially similar to trace architectures described in greater detail above. Additionally, second traces 754 and 755 may be over the traces 714 and 715, respectively. The second traces 754 and 755 may be entirely out of the core 710. That is, the traces 754 and 755 are not embedded in the core 710. In an embodiment, the combination of second trace 754 and trace 714, and second trace 755 and trace 715 results in the formation of traces that have a T-shaped cross-section. In such embodiments, the stem of the T may be embedded within the core 710 and the cross of the T may be above the core 710.

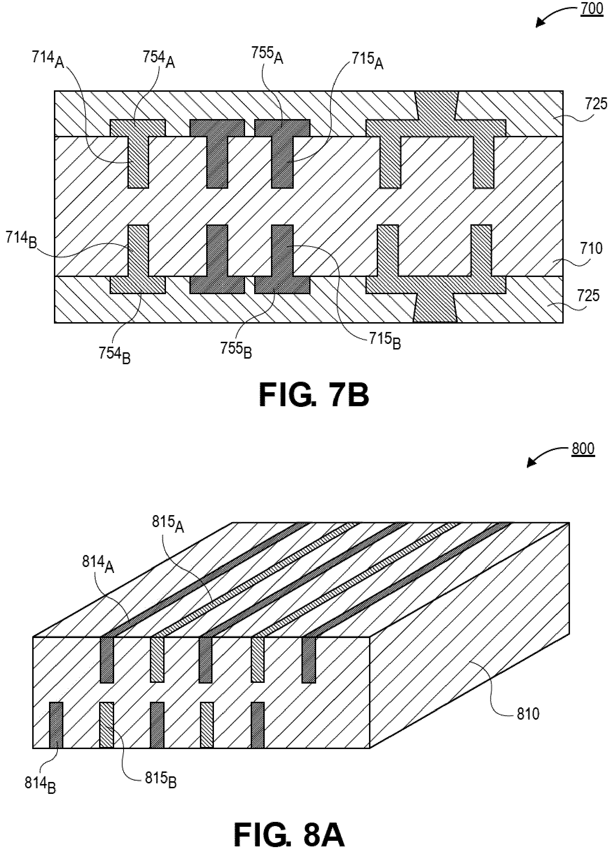

Referring now to Figure 7B, a cross-sectional illustration of an electronic package 700 is shown, in accordance with an additional embodiment. The electronic package 700 in Figure 7B is substantially similar to the electronic package 700 in Figure 7A, with the exception of an additional set of traces at the bottom of the core 710. For example, traces 714_{A}, 715_{A}, 754_{A}, and 755_{A} are at the top of the core 710, and traces 714_{B}, 715_{B}, 754_{B}, and 755_{B} are at the bottom of the core 710. It is to be appreciated that other embodiments may include a structure similar to Figure 7B with only the bottom traces being used. That is, there may be embodiments where there are not traces on the die side of the core 710.

Referring now to Figures 8A-8E, a series of perspective view illustrations of various routing architectures are shown, in accordance with an embodiment. In an embodiment, the routing architectures may include signaling traces and ground traces (or reference traces) that are provided as blind structures into the core 810. In some instances via planes through the thickness of the core 810 may be used for the ground traces instead of blind structures. Additionally, in cases of single-ended HSIO embodiments, the signal trace and the ground lines are shown as alternating. It is to be appreciated that it is possible to have a half-byte (i.e., four signal traces) or a full byte (i.e., eight signal traces) between ground features.

Referring now to Figure 8A, a perspective view illustration of an electronic package 800 with a routing architecture embedded in a core 810 is shown, in accordance with an embodiment. In an embodiment, the routing architecture may be referred to as a staggered, dual-sided, single ended architecture. At the top end of the core 810, signal traces 815_{A} alternate with ground traces 814_{A}. Similarly, at the bottom end of the core 810, signal traces 815_{B} alternate with ground traces 814_{B}. The signal traces 815_{A} may be provided above ground traces 814_{B}, and signal traces 815_{B} may be under ground traces 814_{A}.

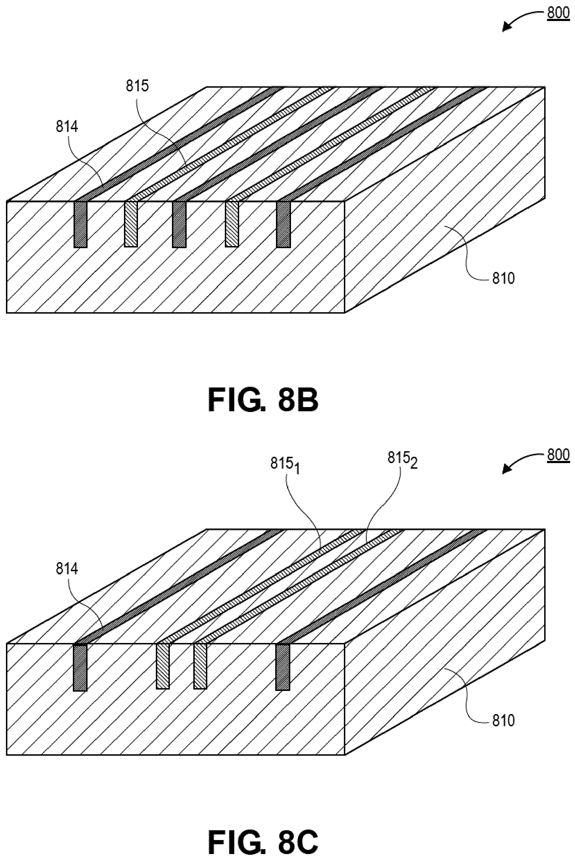

Referring now to Figure 8B, a perspective view illustration of an electronic package 800 with a routing architecture embedded in a core 810 is shown, in accordance with an additional embodiment. In an embodiment, the routing architecture may be referred to as a single-sided, single-ended routing structure. As shown, the ground traces 814 alternate with the signaling traces 815. In the illustrated embodiment, the traces 814 and 815 are provided at the top surface of the core 810. However, in other embodiments, the traces 814 and 815 may be provided at a bottom surface of the core 810.

Referring now to Figure 8C, a perspective view illustration of an electronic package 800 with a routing architecture embedded in a core 810 is shown, in accordance with an additional embodiment. In an embodiment, the routing architecture may be referred to as a single-sided differential-pair. That is, a first signal trace 815₁ may be adjacent to a second signal trace 815₂ in order to provide differential signaling. The traces 815₁ and 815₂ may be between ground traces 814. In the illustrated embodiment, the traces 815 and 814 are shown as being at the top of the core 810. However, it is to be appreciated that the traces 815 and 814 may alternatively be at the bottom of the core 810.

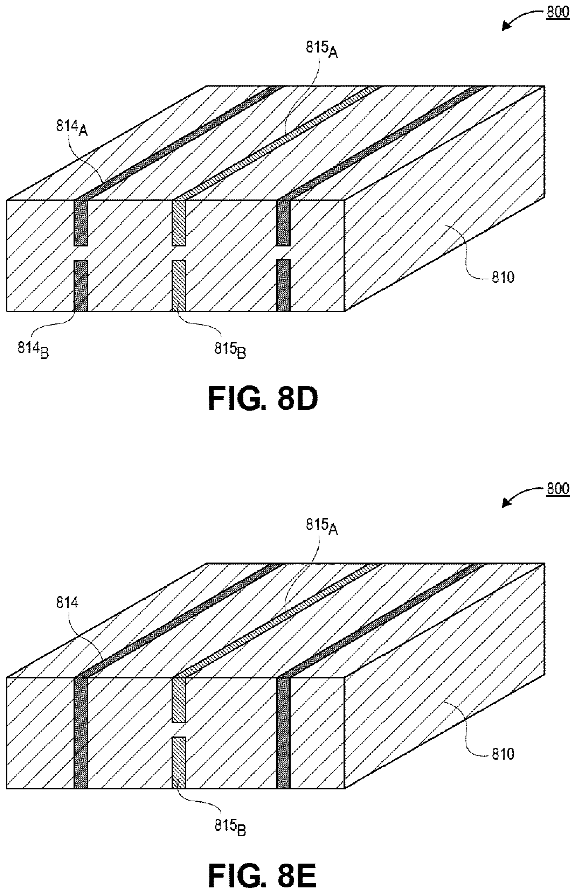

Referring now to Figure 8D, a perspective view illustration of an electronic package 800 with a routing architecture embedded in a core 810 is shown, in accordance with an additional embodiment. In an embodiment, the routing architecture may be referred to as a dual sided, differential-pair with blind ground traces. As shown, a first signal trace 815_{A} is provided at the top of the core 810, and a second signal trace 815_{B} is provided under the first signal trace 815_{A} at a bottom of the core 810. The ground traces 814_{A} and 814_{B} may be blind features provided at the top of the core 810 and the bottom of the core 810.

Referring now to Figure 8E, a perspective view illustration of an electronic package 800 with a routing architecture embedded in a core 810 is shown, in accordance with an additional embodiment. In an embodiment, the routing architecture may be referred to as a dual sided differential-pair with through via traces, That is, the structure may be similar to the structure shown in Figure 8E, with the exception of the traces 814 being a full via through the thickness of the core 810.

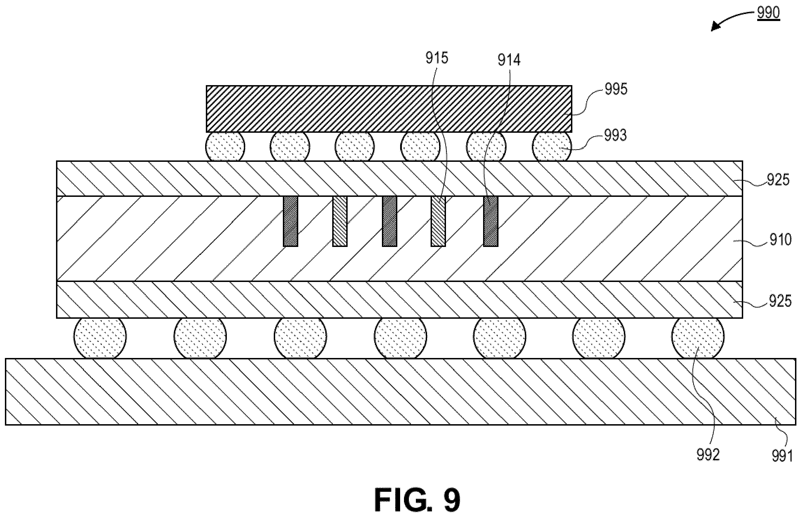

Referring now to Figure 9, a cross-sectional illustration of an electronic system 990 is shown, in accordance with an embodiment. In an embodiment, the electronic system 990 comprises a board 991. For example, the board 991 may be a printed circuit board (PCB) or the like. In an embodiment, the board 991 is coupled to a package substrate that comprises a core 910 and buildup layers 925. The bottom buildup layers 925 may be coupled to the board 991 by interconnects 992. The interconnects 992 may be any suitable SLI interconnect.

In an embodiment, traces 914 and 915 may be embedded in the core 910. In the illustrated embodiments, the traces 914 and 915 are provided at the top of the core 910. In other embodiments, the traces 914 and 915 may be provided at the bottom of the core 910 or at both the top of the core 910 and the bottom of the core 910. In the illustrated embodiment, the traces 914 and 915 are shown with different shadings. However, it is to be appreciated that the traces 914 and 915 may be substantially similar to each other in composition. In an embodiment, the traces 914 are ground traces and the traces 915 are signal traces. In an embodiment, the routing architecture in the core 910 may be similar to any of the routing architectures described herein.

In an embodiment, a die 995 may be coupled to the top buildup layers 925 by interconnects 993. The interconnects 993 may be any FLI interconnect architecture. In an embodiment, the die 995 may be a processor, a graphics processor, a memory die, or any other type of computational die.

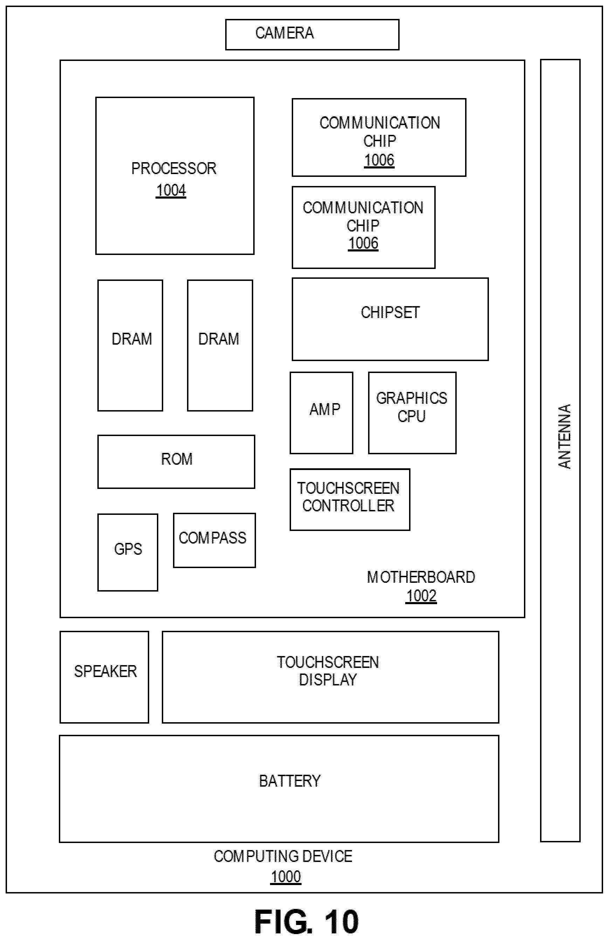

Figure 10 illustrates a computing device 1000 in accordance with one implementation of the invention. The computing device 1000 houses a board 1002. The board 1002 may include a number of components, including but not limited to a processor 1004 and at least one communication chip 1006. The processor 1004 is physically and electrically coupled to the board 1002. In some implementations the at least one communication chip 1006 is also physically and electrically coupled to the board 1002. In further implementations, the communication chip 1006 is part of the processor 1004.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1006 enables wireless communications for the transfer of data to and from the computing device 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing device 1000 includes an integrated circuit die packaged within the processor 1004. In some implementations of the invention, the integrated circuit die of the processor may be part of an electronic package that comprises a glass core with blind via traces that have a width that is less than a height, in accordance with embodiments described herein. The term "processor" may refer to any device or portion of a device that processes electronic data from registers and/or memory to transform that electronic data into other electronic data that may be stored in registers and/or memory.

The communication chip 1006 also includes an integrated circuit die packaged within the communication chip 1006. In accordance with another implementation of the invention, the integrated circuit die of the communication chip may be part of an electronic package that comprises a glass core with blind via traces that have a width that is less than a height, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: an electronic package, comprising: a substrate with a first surface and a second surface opposite from the first surface, wherein the substrate comprises glass; a trace embedded in the substrate, wherein a width of the trace is less than a height of the trace; a first layer on the first surface of the substrate, wherein the first layer is a dielectric buildup film; and a second layer on the second surface of the substrate, wherein the second layer is the dielectric buildup film.

Example 2: the electronic package of Example 1, wherein a top surface of the trace is substantially coplanar with the first surface of the substrate.

Example 3: the electronic package of Example 1 or Example 2, wherein a sidewall of the trace is tapered.

Example 4: the electronic package of Examples 1-3, wherein the trace has a u-shaped cross-section.

Example 5: the electronic package of Example 4, further comprising: a dielectric material filling the u-shaped cross-section.

Example 6: the electronic package of Examples 1-5, further comprising a second trace over a top surface of the trace on the first surface of the substrate.

Example 7: the electronic package of Example 6, wherein a combined cross-section of the trace and the second trace is a T-shaped cross-section.

Example 8: the electronic package of Examples 1-7, wherein a first end of the trace is coupled to a first level interconnect (FLI), and wherein a second end of the trace is coupled to a second level interconnect (SLI), wherein a height of the trace at the second end of the trace is substantially equal to a thickness of the substrate.

Example 9: the electronic package of Example 8, wherein the first end of the trace is within a die shadow of a die coupled to the electronic package, and wherein the second end is outside of the die shadow.

Example 10: the electronic package of Examples 1-9, wherein the trace is adjacent to a second trace embedded in the substrate.

Example 11: an electronic package, comprising: a substrate with a first surface and a second surface opposite from the first surface, wherein the substrate comprises glass; and a signaling architecture at least partially embedded within the substrate, wherein the signaling architecture comprises: a signal trace; and a ground trace.

Example 12: the electronic package of Example 11, wherein the signal trace is laterally adjacent to the ground trace.

Example 13: the electronic package of Example 11 or Example 12, further comprising: a second ground trace, wherein the signal trace is between the second ground trace and the ground trace.

Example 14: the electronic package of Example 13, further comprising: a third ground trace, wherein the third ground trace is below the signal trace.

Example 15: the electronic package of Examples 11-14, further comprising: a second signal trace, wherein the signal trace is adjacent to the second signal trace.

Example 16: the electronic package of Example 15, wherein a spacing between the second signal trace and the signal trace is smaller than a spacing between the signal trace and the ground trace.

Example 17: the electronic package of Example 16, further comprising a second ground trace, wherein the signal trace and the second signal trace are between the ground trace and the second ground trace.

Example 18: the electronic package of Examples 11-17, further comprising a second signal trace, wherein the second signal trace is below signal trace.

Example 19: the electronic package of Example 18, further comprising: a second ground trace, wherein the signal trace and the second signal trace are between the ground trace and the second ground trace.

Example 20: the electronic package of Example 19, wherein the ground trace and the second ground trace both pass through an entire thickness of the substrate.

Example 21: the electronic package of Examples 11-20, wherein the signaling architecture is a single ended interface or a dual sided single ended interface.

Example 22: the electronic package of Examples 11-20, wherein the signaling architecture is a differential signaling pair.

Example 23: an electronic system, comprising: a board; a package substrate coupled to the board, wherein the package substrate comprises: a substrate with a first surface and a second surface opposite from the first surface, wherein the substrate comprises glass; and a trace embedded in the substrate, wherein a width of the trace is less than a height of the trace; and a die coupled to the package substrate.

Example 24: the electronic system of Example 23, wherein a top surface of the trace is substantially coplanar with the first surface of the substrate.

Example 25: the electronic system of Example 23 or Example 24, wherein a first end of the trace is coupled to a first level interconnect (FLI), and wherein a second end of the trace is coupled to a second level interconnect (SLI), wherein a height of the trace at the second end of the trace is substantially equal to a thickness of the substrate, and wherein the first end of the trace is within a die shadow of the die, and wherein the second end is outside of the die shadow of the die.

## Claims

1. An electronic package, comprising:
a substrate with a first surface and a second surface opposite from the first surface, wherein the substrate comprises glass;
a trace embedded in the substrate, wherein a width of the trace is less than a height of the trace;
a first layer on the first surface of the substrate, wherein the first layer is a dielectric buildup film; and
a second layer on the second surface of the substrate, wherein the second layer is the dielectric buildup film.

2. The electronic package of claim 1, wherein a top surface of the trace is substantially coplanar with the first surface of the substrate.

3. The electronic package of claim 1 or 2, wherein a sidewall of the trace is tapered.

4. The electronic package of claim 1, 2 or 3, wherein the trace has a u-shaped cross-section.

5. The electronic package of claim 4, further comprising:
a dielectric material filling the u-shaped cross-section.

6. The electronic package of claim 1, 2, 3, 4 or 5, further comprising a second trace over a top surface of the trace on the first surface of the substrate.

7. The electronic package of claim 6, wherein a combined cross-section of the trace and the second trace is a T-shaped cross-section.

8. The electronic package of claim 1, 2, 3, 4, 5, 6 or 7, wherein a first end of the trace is coupled to a first level interconnect (FLI), and wherein a second end of the trace is coupled to a second level interconnect (SLI), wherein a height of the trace at the second end of the trace is substantially equal to a thickness of the substrate.

9. The electronic package of claim 8, wherein the first end of the trace is within a die shadow of a die coupled to the electronic package, and wherein the second end is outside of the die shadow.

10. The electronic package of claim 1, 2, 3, 4, 5, 6, 7, 8 or 9, wherein the trace is adjacent to a second trace embedded in the substrate.

11. A method of fabricating an electronic package, the method comprising:
providing a substrate with a first surface and a second surface opposite from the first surface, wherein the substrate comprises glass;
forming a trace embedded in the substrate, wherein a width of the trace is less than a height of the trace;
forming a first layer on the first surface of the substrate, wherein the first layer is a dielectric buildup film; and
forming a second layer on the second surface of the substrate, wherein the second layer is the dielectric buildup film.

12. The method of claim 11, wherein a top surface of the trace is substantially coplanar with the first surface of the substrate.

13. The method of claim 11 or 12, wherein a sidewall of the trace is tapered.

14. The method of claim 11, 12 or 13, wherein the trace has a u-shaped cross-section.

15. The method of claim 14, further comprising:
forming a dielectric material filling the u-shaped cross-section.
